# EUROPÄISCHE PATENTSCHRIFT

(11) **EP 2 606 574 B1**
(45) Veröffentlichungstag und Bekanntmachung des Hinweises auf die Patenterteilung: **11.10.2017**
(21) Anmeldenummer: 11757156.2
(22) Anmeldetag: 15.08.2011
(51) Int. Cl.: H03K 17/955, G01D 5/24, G01B 7/14

(54) **KAPAZITIVER ABSTANDSSENSOR**
CAPACITIVE DISTANCE SENSOR
CAPTEUR DE DISTANCE CAPACITIF

(30) Priorität: 21.08.2010 DE 202010011656 U
(43) Veröffentlichungstag der Anmeldung: 26.06.2013
(73) Patentinhaber: Brose Fahrzeugteile GmbH & Co. Kommanditgesellschaft, Bamberg, 96052 Bamberg (DE)
(72) Erfinder: WÜRSTLEIN, Holger, 97475 Zeil am Main (DE); KUHNEN, Thorsten, 96123 Litzendorf (DE)
(74) Vertreter: FDST Patentanwälte
(86) Internationale Anmeldenummer: PCT/EP2011/004087
(87) Internationale Veröffentlichungsnummer: WO 2012/031661

(56) Entgegenhaltungen:
- DE-U1-202006 009 189
- JP-A- 2008 130 366
- US-A1- 2005 092 097

## Beschreibung

Die Erfindung betrifft einen kapazitiven Abstandssensor mit einem langgestreckten Sensorelement, insbesondere für die Anwendung in der Automobilindustrie.

Dort finden solche Sensoren zur Detektion eines sich an ein Fahrzeug oder Fahrzeugteil annäherndes Objekts Verwendung, zum Beispiel als Teil einer Einparkhilfe oder als Teil eines berührungslosen Einklemmschutzes für elektrisch verstellbare Fenster oder Türen. Ein weiteres Anwendungsgebiet derartiger kapazitiver Abstandssensoren liegt in der Raumfahrt oder in der Verwendung bei Industrieanlagen, um berührungslos die Anwesenheit von Personen und/oder Objekten, sowie optional den (quantitativen) Abstand dieser Personen bzw. Objekte zu dem Sensor bestimmen zu können.

Aus der US005166679A ist ein kapazitiver Abstandssensor mit einem eine Sensorfläche umfassenden Sensorelement bekannt, das an einem zu schützenden Element angebracht ist. Die Sensorfläche ist im Wesentlichen eine plane, ausgedehnte, dünne und elektrisch leitende Fläche und bildet eine Elektrode eines Kondensators. Als Gegenelektrode des Kondensators dient ein in den von dem Sensor zu überwachenden Bereich eindringendes Objekt. Bei einer Annäherung des Objekts an das Sensorelement ändert sich die Kapazität des zwischen der Sensorfläche und der Gegenelektrode gebildeten Kondensators. Die Kapazitätsänderung wird direkt und/oder indirekt mittels einer Elektronik gemessen und hieraus der Abstand des Objekts zu dem Sensorelement bestimmt.

Nachteilig bei dieser Sensoranordnung ist, dass ein relativ großer Bereich des zu schützenden Elements durch die Sensorfläche abgedeckt wird.

In der DE 10 2008 031 307 A1 wird ein weiterer kapazitiver Abstandssensor offenbart, dessen Sensorelement ein Koaxialkabel umfasst. Die Seele des Koaxialkabels dient als Sensorfläche, mit Hilfe der die Annäherung eines Objekts an das Sensorelement überwacht wird. Der Außenleiter des Koaxialkabels dient als Abschirmung und ist an bestimmten Stellen abgetragen, so dass nur ein vordefinierter Raumbereich von dem Sensorelement überwacht wird.

Nachteilig bei dieser Ausführungsform ist die vergleichsweise kleine Sensorfläche, die zu einer geringen Kapazität des Sensorelements führt und somit eine aufwändige und deswegen störanfällige Elektronik bedingt.

Weitere langgestreckte Sensorelemente, die zusätzlich zur Erfassung einer Berührung des Sensorelements mittels einer kapazitiven Sensorfläche kapazitiv die Annäherung eines Objekts an das Sensorelement überwachen, sind aus JP 2008 130366 A und US 2005/0092097 A1 bekannt.

Der Erfindung liegt die Aufgabe zugrunde, einen kapazitiven Abstandssensor mit einem langgestreckten Sensorelement anzugeben, das kostengünstig herstellbar ist und gleichzeitig eine vergleichsweise große Sensorfläche zur Erzielung einer großen Kapazität aufweist.

Diese Aufgabe wird erfindungsgemäß gelöst durch die Merkmale des Anspruchs 1. Vorteilhafte Weiterbildungen und Ausgestaltungen sind Gegenstand der Unteransprüche.

Erfindungsgemäß enthält der kapazitive Abstandssensor ein langgestrecktes Sensorelement, das einen Trägerkörper und eine darauf aufgebrachte Sensorfläche umfasst. Der Trägerkörper besteht aus einem elektrisch nichtleitenden Material und weist eine zylindrische Form mit runder Querschnittsfläche auf. Bevorzugt beträgt der Radius der Querschnittsfläche zwischen 0,5mm und 10mm. Die die Zylindermantelfläche umgebende Sensorfläche besteht aus einem elektrisch leitenden Material und weist vorzugsweise eine konstante Dicke auf.

Das solchermaßen gestaltete Sensorelement weist eine große Sensorfläche bei gleichzeitig kleinem Außenmaß auf. Das Sensorelement ist zudem materialsparend und kostengünstig herstellbar. Vorteilhafterweise ist das langgestreckte Sensorelement biegsam ausgestaltet, so dass es an Objekten verschiedenster Geometrien angebracht werden kann.

In einer bevorzugten Ausgestaltung der Erfindung ist die Sensorfläche aus Aluminium oder Kupfer gefertigt. Diese Materialien weisen eine vergleichsweise hohe elektrische Leitfähigkeit bei einem vergleichsweise niedrigen Gewicht sowie gute Bearbeitbarkeit auf und sind in der industriellen Fertigung weit verbreitet. Der Trägerkörper besteht vorteilhafterweise aus Polyethylen.

Zweckmäßigerweise ist die Sensorfläche zur Vermeidung von fehlerhaften Messwerten von einer elektrisch nichtleitenden Isolierschicht umgeben. Diese Isolierschicht dient auch zum Schutz der Sensorfläche vor mechanischen oder chemischen Beschädigungen durch verschiedene Umwelteinflüsse.

Die Sensorfläche kann im Rahmen der Erfindung durch eine Folie gebildet werden. In einer besonders geeignete Ausführung jedoch besteht die Sensorfläche aber aus einem Drahtgeflecht, das insbesondere den Vorteil einer hohen Strapazierfähigkeit und einer großen räumlichen Anpassungsfähigkeit hat.

In einer zweckmäßigen Variante der Erfindung besteht der Trägerkörper aus Vollmaterial. In einer alternativen Ausführungsform hat der Trägerkörper die Form eines Hohlzylinders und weist somit mittig eine Aussparung auf, die sich im Lot zur Querschnittsfläche über die gesamte Länge der Zylinderform erstreckt. Nicht unter die beanspruchte Erfindung fallend, kann die Aussparung aus Gründen der Material- und/oder Gewichtseinsparung leer sein. Erfindungsgemäß ist diese Aussparung aber mit einer Seele ausgefüllt. Das Sensorelement weist somit den Aufbau eines herkömmlichen Koaxialkabels auf und kann hierdurch auf herkömmlichen Maschinen, die Koaxialkabel herstellen, produziert werden. Die Seele besteht aus einem elektrisch nichtleitenden Material, was eine kostengünstige Herstellung des Sensorelements zulässt. Nicht unter die beanspruchte Erfindung fallend, kann die Seele auch aus einem elektrisch leitenden Material, insbesondere aus Kupfer, bestehen, insbesondere zumal das Innere des Sensorelements durch die umgebende Sensorfläche ohnehin abgeschirmt ist. Optional kann die Seele hierbei elektrisch leitend mit der Sensorfläche kurzgeschlossen sein, insbesondere an den jeweiligen Enden des langgestreckten Sensorelements.

Mindestens ein Längsende des Sensorelements ist durch einen dicht mit der Isolierschicht verbundenen Abschluss hermetisch von der Umwelt angeschlossen, so dass die Sensorschicht auch an dem Längsende gegen Wasser und Schmutz geschützt ist. Der Abschluss besteht vorzugsweise aus Macromelt und ist an das Sensorelement angespritzt oder angegossen. Alternativ können die Abschlüsse auf das Ende des Sensorelements aufgesteckt und mit der Isolierschicht dicht verschweißt oder verklebt sein. In mindestens einen der Abschlüsse ist bevorzugt eine Kontaktstelle eingebettet, an der die Sensorfläche mit einer elektrischen Anschlussleitung kontaktiert ist.

Die Aufgabe der Erfindung wird ebenfalls gelöst durch ein Sensorelement für einen kapazitiven Abstandssensor mit den oben genannten Merkmalen sowie durch die Verwendung eines Sensorelements mit den oben genannten Merkmalen in einem kapazitiven Abstandssensor.

Nachfolgend werden Ausführungsbeispiele anhand einer Zeichnung näher erläutert. Darin zeigen:
- Fig. 1: schematisch einen kapazitiven Abstandssensor mit einem langgestreckten Sensorelement,
- Fig. 2: ausschnittsweise perspektivisch das Sensorelement gemäß Fig. 1 ,
- Fig. 3: im Querschnitt das Sensorelement gemäß Fig. 1, und
- Fig. 4: in Darstellung gemäß Fig. 3 eine alternative Ausführungsform des Sensorelements.

Einander entsprechende Teile sind in allen Figuren mit den gleichen Bezugszeichen versehen.

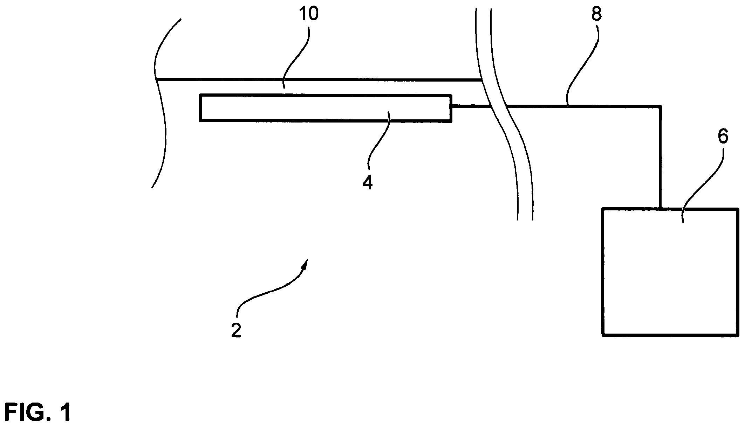

In Fig. 1 ist schematisch ein kapazitiver Abstandssensor 2 dargestellt. Der Abstandssensor 2 umfasst ein langgestrecktes, flexibles Sensorelement 4, eine Elektronik 6 sowie eine das Sensorelement 4 mit der Elektronik 6 elektrisch verbindende Anschlussleitung 8. Beispielsweise befindet sich der Abstandssensor 2 innerhalb eines Kraftfahrzeugs und dient im Rahmen einer schlüssellosen Startautomatik (Keyless-Go) der Überwachung einer Annäherung einer Person an das geparkte Kraftfahrzeug. In einem zweckmäßigen Anwendungsfall ist das Sensorelement 4 im Heckbereich des Kraftfahrzeugs, beispielsweise an dem hinteren Stoßfänger 10 angebracht. Zur Abdeckung eines möglichst großen Überwachungsbereichs erstreckt sich das Sensorelement 4 geeigneterweise über die gesamte Breite des Kraftfahrzeugs.

Die Elektronik 6 versorgt das Sensorelement 4 mit Strom und wertet die Messdaten des Sensorelements 4 aus. Insbesondere kann aufgrund eines von dem Abstandssensor 2 emittierten Signals die Heckklappe des Kraftfahrzeugs geöffnet werden, so dass die sich nähernde Person keine manuelle Tätigkeit zum Öffnen der Klappe vornehmen, die Klappe also nicht per Hand öffnen muss.

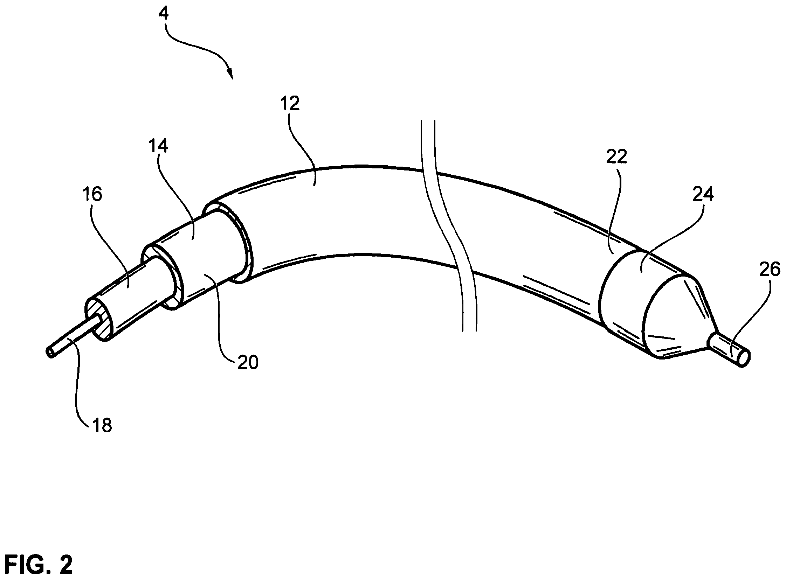

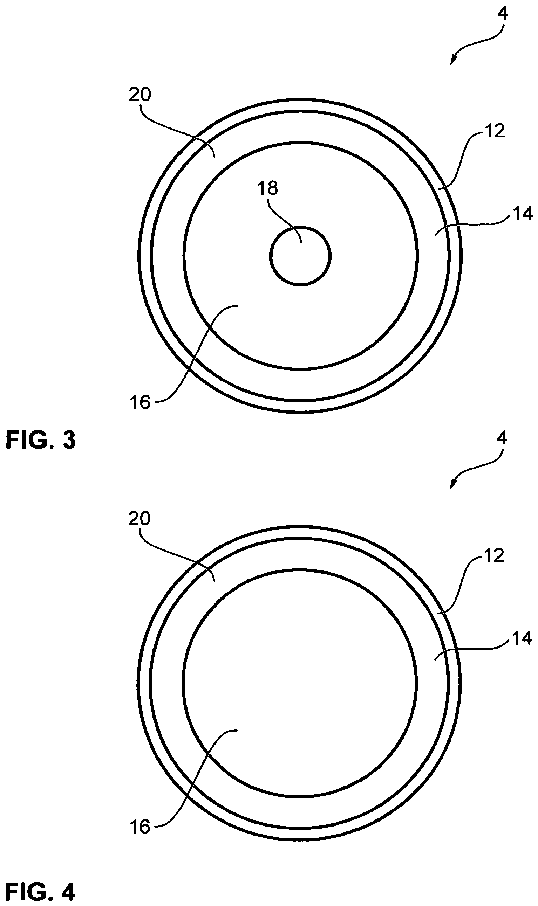

In Fig. 2 und 3 ist das Sensorelement 4 näher dargestellt. Wie aus der Darstellung ersichtlich, ist das Sensorelement 4 zylinderförmig und weist eine Zwiebelschalenstruktur auf, die aus mehreren koaxialen schlauchähnlichen Schichten, nämlich einer Isolierschicht 12, einer Sensorfläche 14 und einem Trägerkörper 16 gebildet wird. Zentral im Inneren des Sensorelements 4 befindet sich eine Seele 18. Der Außendurchmesser des gesamten Sensorelements 4 kann zwischen 2mm und 30mm betragen. In beispielhafter Dimensionierung beträgt der Außendurchmesser etwa 7mm.

Die Seele 18 besteht erfindungsgemäß aus einem nichtleitenden Kunststoff, insbesondere Polyethylen. Alternativ kann die Seele 18 auch aus Kupfer bestehen. Die Seele 18 wird mantelartig von einem elektrisch nichtleitenden Trägerkörper 16 umgeben, der beispielsweise aus Polyethylen besteht.

An die Mantelfläche des Trägerkörpers 16 schließt sich eine Sensorfläche 14 an. Diese aus Kupfer, wahlweise auch aus Aluminium bestehende Schicht wird durch ein Drahtgeflecht 20 gebildet. Vorstellbar wäre allerdings auch, die Sensorfläche 14 anstatt aus dem Geflecht 20 aus einer Metallfolie herzustellen. Zur Vermeidung eines Kurzschlusses und zum Schutz der Sensorfläche 14 gegenüber Umwelteinflüssen wie zum Beispiel Korrosion oder mechanische Beschädigungen ist die Sensorfläche 14 von einer Isolierschicht 12 umgeben.

An einem Ende 22 des Sensorelements 4 befindet sich ein Abschluss 24. Der Körper des Abschlusses 24 besteht aus Macromelt und ist an das Sensorelement 4 angegossen. In den Abschluss 24 ist eine Anschlussstelle 26 eingebettet, an der die Sensorfläche 14 mit der Anschlussleitung 8 kontaktiert ist.

Dem prinzipiellen Schichtaufbau nach entspricht das in den Fig. 2 und Fig. 3 dargestellte Sensorelement 4 etwa einem herkömmlichen Koaxialkabel. Dies ermöglicht es, das Sensorelement 4 auf einer herkömmlichen Maschine zur Herstellung für Koaxialkabel zu produzieren.

Fig. 4 zeigt eine weitere Ausführungsform des Sensorelements 4 im Querschnitt. Der wesentliche Unterschied zu dem in Fig. 2 und Fig. 3 gezeigten Sensorelement 4 besteht darin, dass das in Fig. 4 gezeigte Sensorelement 4 keine Seele 18 aufweist. Der Trägerkörper 16 besteht hier vielmehr aus einem Vollmaterial, insbesondere aus Polyethylen.

Der Abstandssensor 2 detektiert die Annäherung einer Person bestimmungsgemäß berührungslos. Hierzu wird an das Sensorelement 4 im Betrieb des Abstandssensors 2 durch die Elektronik 6 eine elektrische Wechselspannung angelegt, unter deren Wirkung sich in einem dem Sensorelement 4 vorgelagerten Raum ein elektrisches Feld ausbildet. Zwischen dem Sensorelement 4 und Masse oder zwischen dem Sensorelement 4 und einem gegebenenfalls vorhandenen weiteren Sensorelement des Abstandssensors 2 wird hierbei ein elektrischer Kondensator gebildet, dessen elektrische Kapazität durch die Elektronik 6 gemessen wird.

Die Funktion des Abstandssensors 2 beruht hierbei auf dem physikalischen Effekt, dass bei Einbringen von menschlichem Körpergewebe in das elektrische Feld die an dem Sensorelement 6 messbare Kapazität mit abnehmendem Abstand des Körpergewebes zu dem Sensorelement 4 zunehmend verändert wird.

## Patentansprüche

1. Kapazitiver Abstandssensor (2) mit einem langgestreckten Sensorelement (4), wobei das Sensorelement (4) einen zylindrischen Trägerkörper (16) aus einem elektrisch nichtleitenden Material mit einer runden Querschnittsfläche sowie eine den Trägerkörper (16) nach Art eines Mantels umfänglich umgebende Sensorfläche (14) aus einem elektrisch leitenden Material umfasst,
**dadurch gekennzeichnet,**
**dass** der Trägerkörper (16) aus Vollmaterial besteht.

2. Kapazitiver Abstandssensor (2) mit einem langgestreckten Sensorelement (4), wobei das Sensorelement (4) einen zylindrischen Trägerkörper (16) aus einem elektrisch nichtleitenden Material mit einer runden Querschnittsfläche sowie eine den Trägerkörper (16) nach Art eines Mantels umfänglich umgebende Sensorfläche (14) aus einem elektrisch leitenden Material umfasst, und wobei der Trägerkörper (16) mittig eine Aussparung aufweist, die sich im Lot zur Querschnittsfläche über die gesamte Länge der Zylinderform des Trägerkörpers (16) erstreckt,
**dadurch gekennzeichnet,**
**dass** die Aussparung mit einer aus einem elektrisch nichtleitenden Material bestehenden Seele (18) ausgefüllt ist.

3. Kapazitiver Abstandssensor (2) nach Anspruch 1 oder 2,
**dadurch gekennzeichnet,**
**dass** das elektrisch leitende Material der Sensorfläche (14) Kupfer oder Aluminium ist.

4. Kapazitiver Abstandssensor (2) nach einem der Ansprüche 1 bis 3,
**dadurch gekennzeichnet,**
**dass** das elektrisch nichtleitende Material des Trägerkörpers (16) Polyethylen ist.

5. Kapazitiver Abstandssensor (2) nach einem der Ansprüche 1 bis 4,
**dadurch gekennzeichnet,**
**dass** die Sensorfläche (14) von einer elektrisch nichtleitenden Isolierschicht (12) umgeben ist.

6. Kapazitiver Abstandssensor (2) nach einem der Ansprüche 1 bis 5,
**dadurch gekennzeichnet,**
**dass** die Sensorfläche (14) aus einem Drahtgeflecht (20) besteht.

7. Sensorelement (4) nach einem der Ansprüche 1 bis 6 für einen kapazitiven Abstandssensor (2).

8. Verwendung eines Sensorelements (4) nach einem der Ansprüche 1 bis 6 in einem kapazitiven Abstandssensor (2).

## Claims

1. Capacitive distance sensor (2) having an elongated sensor element (4), wherein the sensor element (4) comprises a cylindrical carrier body (16) made from a non-electrically conductive material having a round cross-sectional area, as well as comprising a sensor surface (14) made from an electrically conductive material, said sensor surface enclosing the carrier body (16) on its periphery in the manner of a casing,
**characterised in that**
the carrier body (16) consists of solid material.

2. Capacitive distance sensor (2) having an elongated sensor element (4), wherein the sensor element (4) comprises a cylindrical carrier body (16) made from a non-electrically conductive material having a round cross-sectional area, as well as comprising a sensor surface (14) made from an electrically conductive material, said sensor surface enclosing the carrier body (16) on its periphery in the manner of a casing, and wherein the carrier body (16) has a recess at its centre which extends perpendicularly relative to the cross-sectional area over the entire length of the cylindrical shape of the carrier body (16),
**characterised in that**
the recess is filled with a cable core (18) consisting of a non-electrically conductive material.

3. Capacitive distance sensor (2) according to claim 1 or 2,
**characterised in that**
the electrically conductive material of the sensor surface (14) is copper or aluminium.

4. Capacitive distance sensor (2) according to one of claims 1 to 3,
**characterised in that**
the non-electrically conductive material of the carrier body (16) is polyethylene.

5. Capacitive distance sensor (2) according to one of claims 1 to 4,
**characterised in that**
the sensor surface (14) is enclosed by a non-electrically conductive insulating layer (12).

6. Capacitive distance sensor (2) according to one of claims 1 to 5,
**characterised in that**
the sensor surface (14) consists of a wire mesh (20).

7. Sensor element (4) according to one of claims 1 to 6 for a capacitive distance sensor (2).

8. Use of a sensor element (4) according to one of claims 1 to 6 in a capacitive distance sensor (2).

## Revendications

1. Capteur de proximité ou de distance capacitif (2) comportant un élément de capteur (4) allongé, l'élément de capteur (4) comprenant un corps porteur (16) cylindrique en un matériau électriquement non conducteur avec une surface de section transversale ronde, ainsi qu'une surface de capteur (14), qui entoure de manière périphérique le corps porteur (16) à la manière d'une enveloppe et est réalisée en un matériau électriquement conducteur,
**caractérisé**
**en ce que** le corps porteur (16) est en un matériau plein.

2. Capteur de proximité ou de distance capacitif (2) comportant un élément de capteur (4) allongé, l'élément de capteur (4) comprenant un corps porteur (16) cylindrique en un matériau électriquement non conducteur et avec une surface de section transversale ronde, ainsi qu'une surface de capteur (14), qui entoure de manière périphérique le corps porteur (16) à la manière d'une enveloppe et est réalisée en un matériau électriquement conducteur, et le corps porteur (16) présentant au centre un évidement, qui s'étend de manière normale à la surface de section transversale sur toute la longueur de la forme de cylindre du corps porteur (16),
**caractérisé**
**en ce que** l'évidement est rempli d'une âme (18) constituée d'un matériau électriquement non conducteur.

3. Capteur de proximité ou de distance capacitif (2) selon la revendication 1 ou la revendication 2,
**caractérisé**
**en ce que** le matériau électriquement conducteur de la surface de capteur (14) est du cuivre ou de l'aluminium.

4. Capteur de proximité ou de distance capacitif (2) selon l'une des revendications 1 à 3,
**caractérisé**
**en ce que** le matériau électriquement non conducteur du corps porteur (16) est du polyéthylène.

5. Capteur de proximité ou de distance capacitif (2) selon l'une des revendications 1 à 4,
**caractérisé**
**en ce que** la surface de capteur (14) est entourée d'une couche isolante (12) électriquement non conductrice.

6. Capteur de proximité ou de distance capacitif (2) selon l'une des revendications 1 à 5,
**caractérisé**
**en ce que** la surface de capteur (14) est constituée par une tresse de fils (20).

7. Elément de capteur (4) selon l'une des revendications 1 à 6, destiné à un capteur de proximité ou de distance capacitif (2).

8. Utilisation d'un élément de capteur (4) selon l'une des revendications 1 à 6, dans un capteur de proximité ou de distance capacitif (2).
